# EUROPÄISCHE PATENTANMELDUNG

(11) **EP 1 622 432 A2**
(43) Veröffentlichungstag der Anmeldung: **01.02.2006**
(21) Anmeldenummer: 05014706.5
(22) Anmeldetag: 06.07.2005
(51) Int. Cl.: H05K 1/02, H05K 7/20

(54) **Leiterplatte und Verfahren zur Herstellung einer solchen Leiterplatte**

(30) Priorität: 30.07.2004 DE 102004036960
(71) Anmelder: Patent -Treuhand-Gesellschaft für elektrische Glühlampen mbH, 81543 München (DE)
(72) Erfinder: Müller, Patrick, 85757 Karlsfeld (DE); Hockel, Jens Florian, 80801 München (DE)
(74) Vertreter: Epping - Hermann - Fischer

(57) **Zusammenfassung**

Es wird eine Leiterplatte angegeben, mit einer thermisch leitende und elektrisch isolierenden Schicht (1) an der Oberseite der Leiterplatte (6) und ein Wärmeleitelement (2), das die Schicht (1) thermisch mit der Unterseite der Leiterplatte (6) verbindet. Ferner wird ein Verfahren zur Herstellung einer solchen Leiterplatte (6) angegeben. Die Leiterpatte (6) zeichnet sich dabei besonders durch ihre guten Wärmeleiteigenschaften aus.

## Beschreibung

Die Erfindung betrifft eine Leiterplatte. Darüber hinaus betrifft die Erfindung ein Verfahren zur Herstellung einer Leiterplatte.

Aus der Druckschrift DE 102 349 95 A1 ist eine Leuchtdiodenanordnung bekannt, bei der ein Leuchtdiodenbauelement auf einer elektrisch leitenden Anschlussplatte befestigt ist. Die elektrisch leitende Anschlussplatte umfasst einen Trägerkörper, in dem ein gegenüber dem Material des Trägerkörpers besser wärmeleitender Einsatz angeordnet ist.

Es ist Aufgabe der vorliegenden Erfindung, eine Leiterplatte mit verbesserten Wärmeleiteigenschaften anzugeben. Ferner ist es Aufgabe der Erfindung, ein Verfahren zur Herstellung einer solchen Leiterplatte anzugeben.

Diese Aufgabe wird gelöst durch eine Leiterplatte nach Patentanspruch 1 und ferner durch ein Verfahren nach Patentanspruch 19. Vorteilhafte Ausgestaltungen der Erfindung sind Gegenstand von Unteransprüchen.

Es wird eine Leiterplatte angegeben, die eine thermisch leitende und elektrisch isolierende Schicht aufweist. Die thermisch leitende und elektrisch isolierende Schicht befindet sich beispielsweise an der Oberseite der Leiterplatte. Die Leiterplatte weist beispielsweise einen Grundkörper auf, der ein elektrisch isolierendes Material enthält. Auf zumindest Teile der Oberfläche des Grundkörpers der Leiterplatte sind strukturierte Leiterbahnen, die ein elektrisch leitendes Material enthalten, aufgebracht. Über die Leiterbahnen kann beispielsweise ein auf der Leiterplatte zu befestigendes Bauteil elektrisch kontaktiert werden.

Weiter weist die Leiterplatte ein Wärmeleitelement auf. Das Wärmeleitelement verbindet die thermisch leitende und elektrisch isolierende Schicht mit der Unterseite der Leiterplatte.

Bevorzugt besteht dazu zwischen der Schicht und wenigstens einem Teil der Oberfläche des Wärmeleitelements ein flächiger Kontakt. Über diesen flächigen Kontakt ist die Schicht thermisch an das Wärmeleitelement gekoppelt, sodass Wärme von der Schicht - vorzugsweise mittels Wärmeleitung - zum Wärmeleitelement übergehen kann. Die Wärme wird vom Wärmeleitelement bevorzugt wiederum größtenteils mittels Wärmeleitung zur Unterseite der Leiterplatte weitergeleitet.

Größtenteils mittels Wärmeleitung heißt in diesem Zusammenhang, dass auch andere Mechanismen der Wärmeabgabe, wie beispielsweise Wärmestrahlung, möglich sind. Diese Anteile spielen jedoch eine untergeordnete Rolle und tragen höchstens einen vernachlässigbar kleinen Anteil zur Wärmeabgabe bei.

Vom Wärmeleitelement kann die Wärme an die Unterseite der Leiterplatte abgegeben werden und von dort flächig auf die Unterseite der Leiterplatte verteilt werden. Es ist aber auch möglich, dass die Wärme vom Wärmeleitelement beispielsweise an einen auf der Unterseite der Leiterplatte angebrachten Kühlkörper abgegeben wird, ohne vorher in der Fläche der Unterseite der Leiterplatte verteilt zu werden.

In einer Ausführungsform der Leiterplatte enthält die thermisch leitende und elektrisch isolierende Schicht wenigstens ein Material, das einen spezifischen elektrischen Widerstand von wenigstens 10² Ωm aufweist. Bevorzugt weist die Schicht einen spezifischen elektrischen Widerstand von wenigstens 10⁵ Ωm auf, besonders bevorzugt von wenigstens 10⁹ Ωm.

Weiter weist das Material eine thermische Leitfähigkeit von wenigstens 100 W/mK auf, bevorzugt von wenigstens 300 W/mK, besonders bevorzugt von wenigstens 600 W/mK auf.

In einer Ausführungsform der Leiterplatte zeichnet sich das Material zudem durch eine Härte von wenigstens 2 nach der Skala von Moh aus. Bevorzugt beträgt die Härte wenigstens 5, besonders bevorzugt wenigstens 8. Die Härte von reinem Diamant beträgt nach dieser Skala 10.

Die thermisch leitende und elektrisch isolierende Schicht weist in einem weiteren Ausführungsbeispiel der Leiterplatte zusätzlich eine Mikrohärte nach Vickers von wenigstens 500 kg/mm², bevorzugt von wenigstens 1000 kg/mm², besonders bevorzugt von wenigstens 2000 kg/mm² auf.

Weiter ist die Schicht bevorzugt besonders temperaturbeständig. Die Schicht ist an Luft bis wenigstens 150°C temperaturbeständig, bevorzugt ist die Schicht bis wenigsten 250°C temperaturbeständig, besonders bevorzugt bis wenigstens 350°C.

Die Schicht kann sich auch durch eine hohe Korrosionsbeständigkeit auszeichnen. Besonders bevorzugt ist die Schicht gegen Salze, Säuren und Laugen beständig.

Zusammenfassend ist die Schicht zumindest sehr gut thermisch leitend, sehr gut elektrisch isolierend oder mechanisch, beispielsweise gegen Kratzer, besonders beständig. Bevorzugt weist die Schicht wenigstens zwei der genannten Eigenschaften auf. Besonders bevorzugt zeichnet sich die Schicht dadurch aus, dass sie sehr gut thermisch leitend, sehr gut elektrisch isolierend und zudem mechanisch besonders beständig ist. Zudem ist die Schicht bevorzugt besonders temperatur- und korrosionsbeständig.

Die Dicke der thermisch leitenden und elektrisch isolierenden Schicht beträgt in einer Ausführungsform der Leiterplatte zwischen 1 µm und 3 *µ*m. Die Schichtdicke ist dabei beispielsweise an die dielektrische Konstante des Schichtmaterials angepasst. Sie wird bevorzugt so dick gewählt, dass ein elektrischer Durchbruch beim Betrieb eines auf der Leiterplatte befestigten Bauteils möglichst verhindert werden kann.

Die Schicht kann dazu beispielsweise diamantartigen Kohlenstoff enthalten. Diamantartiger Kohlenstoff, auch bekannt als diamond-like carbon (DLC), zeichnet sich durch eine besonders gute thermische Leitfähigkeit, einen hohen elektrischen Widerstand und eine hohe mechanische Belastbarkeit aus. Die thermische Leitfähigkeit von diamantartigem Kohlenstoff beträgt bis zu 700 W/mK, der spezifische elektrische Widerstand beträgt ca. 10¹⁰ Ωm, die dielektrische Konstante beträgt ca. 8, die Härte nach Moh von diamantartigem Kohlenstoff beträgt 9, und die Härte nach Vickers einer Schicht, die diamantartigen Kohlenstoff enthält, beträgt zwischen 2000 und 5000 kg/mm².

Neben diamantartigem Kohlenstoff sind aber auch Schichten aus anderen Materialien wie beispielsweise anderen diamantartigen Materialien (diamond-like nanocomposites - DLN) denkbar.

In einer bevorzugten Ausführungsform der Leiterplatte verbindet das Wärmeleitelement die thermische leitende und elektrisch isolierende Schicht auf direktem Weg mit der Unterseite der Leiterplatte. Das heißt, das Wärmeleitelement stellt eine thermische Verbindung zwischen Schicht und Unterseite der Leiterplatte dar, bei der beispielsweise an der Schicht in das Wärmeleitelement eintretende Wärme auf im wesentlichen geraden Weg zur Unterseite der Leiterplatte weitergeleitet werden kann. Im Wesentlichen gerade heißt dabei, dass ein Teil der an der Schicht in das Wärmeleitelement eintretenden Wärme beispielsweise seitlich an den Grundkörper der Leiterplatte abgegeben werden kann. Ein Großteil der Wärme wird jedoch vom Wärmeleitelement direkt von der Leiterplattenoberseite zur Leiterplattenunterseite weitergeführt.

In einer weiteren Ausführungsform der Leiterplatte ist die thermisch leitende und elektrisch isolierende Schicht durch eine Beschichtung zumindest eines Teils der Oberfläche des Wärmeleitelements gegeben. Beispielsweise ist derjenige Teil der Oberfläche des Wärmeleitelements beschichtet, der sich auf der Seite der Oberseite der Leiterplatte befindet.

Die Beschichtung des Wärmeleitelements kann beispielsweise durch ein Plasmabeschichtungsverfahren, wie PECVD (Plasma Enhanced Chemical Vapor Deposition) erfolgen. Eine auf diese Weise hergestellte Schicht zeichnet sich besonders durch ihre gleichmäßige Dicke und homogene Zusammensetzung aus.

Das Wärmeleitelement enthält in einer Ausführungsform der Leiterplatte ein Halbleitermaterial oder ein Metall. Bevorzugt enthält das Wärmeleitelement beispielsweise Kupfer. Besonders bevorzugt besteht das Wärmeleitelement aus Kupfer.

In einer weiteren Ausführungsform der Leiterplatte weist die Leiterplatte einen Durchbruch auf, in dem das Wärmeleitelement angeordnet ist. Der Durchbruch kann beispielsweise eine Bohrung durch die Leiterplatte sein. In den Durchbruch ist das Wärmeleitelement beispielsweise gesteckt. Zur mechanischen Befestigung kann das Wärmeleitelement beispielsweise mittels eines thermisch beständigen Klebstoffs mit dem Grundkörper der Leiterplatte verklebt sein. Es sind jedoch auch andere Befestigungsarten wie beispielsweise Löten möglich, um das Wärmeleitelement im Durchbruch zu befestigen.

Bei der Leiterplatte kann es sich um eine handelsübliche, doppelseitig beschichtete FR4-Platine handeln. Dies hat den Vorteil, dass es sich bei der beschriebenen Leiterplatte um eine besonders kostengünstige Alternative zu Metallkernplatinen (MCPCB - Metall Core Printed Circuit Board) handelt, welche üblicherweise in Verbindung mit stark wärmeerzeugenden Bauteilen Verwendung finden.

In einer weiteren Ausführungsform ist die Leiterplatte an ihrer Unterseite mit einem thermisch leitenden und elektrisch isolierenden Material beschichtet. Diese Unterseitenbeschichtung bedeckt bevorzugt sowohl die Unterseite des Leiterplattengrundkörpers als auch den Wärmeleiter zumindest teilweise.
Bevorzugt besteht zwischen dem Bereich der Unterseitenbeschichtung, der das Wärmeleitelement bedeckt, und dem Bereich, der die restliche Unterseite der Leiterplatte bedeckt, eine Verbindung. Auf diese Weise ist es möglich, die vom Wärmeleiter abgegebene Wärme auf der Unterseite der Leiterplatte zu verteilen. Die Wärme kann dann besonders großflächig von der Unterseite an die Umgebung abgegeben werden. Beispielsweise kann die Leiterplatte mit ihrer Unterseite thermisch an einen Kühlkörper gekoppelt sein, sodass die Wärme von der Unterseite der Leiterplatte großflächig an den Kühlkörper abgegeben wird.

Besonders bevorzugt ist die Unterseitenbeschichtung zwischen 1 µm und 3 µm dick. Eine solch geringe Dicke der Unterseitenbeschichtung trägt dazu bei, dass die Wärme auf der Unterseite bevorzugt flächig verteilt wird.

Die Unterseitenbeschichtung enthält beispielsweise diamantartigen Kohlenstoff. Neben der guten thermischen Leitfähigkeit und dem hohen elektrischen Widerstand zeichnet sich die Unterseitenbeschichtung dann zusätzlich noch durch eine hohe mechanische Beständigkeit aus, die einen Schutz der Leiterplatte beispielsweise vor Verkratzen bietet. Bevorzugt ist die Unterseitenbeschichtung dabei mittels eines Plasmabeschichtungsverfahrens auf der Unterseite der Leiterplatte aufgebracht.

Es wird ferner eine optoelektronische Anordnung angegeben, die eine der beschriebenen Leiterplatten und ein optoelektronisches Bauteil aufweist.

Bevorzugt befindet sich das optoelektronische Bauteil zumindest stellenweise in Kontakt mit der thermisch leitenden und elektrisch isolierenden Schicht. Dazu kann die Schicht beispielsweise durch eine zumindest teilweise Beschichtung des Teils des optoelektronischen Bauteils gegeben sein, der sich in Kontakt mit dem Wärmeleitelement befindet.

Beispielsweise ist die Schicht auf eine Fläche des Bauteils aufgebracht, durch die besonders viel Wärme ausgekoppelt werden kann. Dabei kann es sich beispielsweise um Teilbereiche der freiliegenden Fläche eines thermischen Anschlussteils des optoelektronischen Bauteils handeln.
Es ist darüber hinaus auch möglich, dass die Schicht direkt auf zumindest Teile der Oberfläche des Halbleiterchips oder der Halbleiterchips des optoelektronischen Bauteils aufgebracht ist oder, dass die Schicht auf zumindest Teile einer Kontaktmetallisierung des Halbleiterchips aufgebracht ist. Die beim Betrieb des Bauteils im Chip erzeugte Wärme kann auf diese Weise direkt an das Wärmeleitelement abgegeben werden.

Es ist auch möglich, dass sich die Schicht als Beschichtung auf der Oberfläche des Wärmeleitelements befindet und das optoelektronische Bauteil frei von einer solchen Beschichtung ist. Zumindest ein Teil des optoelektronischen Bauteils liegt dann auf der Schicht auf, oder ist auf der Schicht befestigt. Das Bauteil kann beispielsweise mittels eines thermisch beständigen Klebstoffs oder mittels eines Lotes auf der Schicht befestigt sein. Es ist dabei möglich, dass ein thermisches Anschlussteil des Chips zumindest teilweise auf der Schicht aufliegt. Es ist aber auch möglich, dass zumindest Teile des Halbleiterchips auf der Schicht direkt aufliegen.

In einer weiteren Ausführungsform der optoelektronischen Anordnung ist es zudem möglich, dass wenigstens der Teil des optoelektronischen Bauteils, der sich in Kontakt mit der Schicht befindet, zumindest teilweise mit einem thermisch leitenden und elektrisch isolierenden Material beschichtet ist. Die Beschichtung des Bauteils und die Schicht befinden sich bevorzugt in thermischem Kontakt zueinander. Die Schicht kann dabei beispielsweise durch eine Beschichtung der Oberfläche des Wärmeleitelements gegeben sein, die der Beschichtung des Bauteils zugewandt ist. Bevorzugt enthält die Beschichtung des optoelektronischen Bauteils diamantartigen Kohlenstoff. Besonders bevorzugt enthält sowohl die Schicht auf dem Wärmeleitelement als auch die Beschichtung des optoelektronischen Bauteils diamantartigen Kohlenstoff. Besonders bevorzugt bestehen beide Schichten aus diamantartigem Kohlenstoff.

In einer weiteren Ausführungsform der optoelektronischen Anordnung weist das Bauteil eine elektrische Leistungsaufnahme von wenigstens 1 W auf. Solche Bauteile erzeugen im Betrieb für gewöhnlich eine hohe Wärmeleistung. Es müssen daher Maßnahmen ergriffen werden, um die Wärme besonders schnell und effizient vom Bauteil abzuleiten. Die angegebene Leiterplatte stellt hier eine besonders kostengünstige Alternative zu den üblicherweise verwendeten Metallkernplatinen dar.

Es ist weiter ein Verfahren zur Herstellung einer Leiterplatte angegeben. Zunächst wird dazu eine Leiterplatte bereitgestellt. Bei der Leiterplatte kann es sich beispielsweise um eine handelsübliche, bedruckte Leiterplatte (Printed Circuit Board - PCB) handeln, wie beispielsweise eine beiderseitig mit Kupfer beschichtete FR4-Platte.

Im folgenden Verfahrensschritt wird in der Leiterplatte ein Durchbruch hergestellt. Der Durchbruch kann beispielsweise mittels Durchbohren oder Durchstanzen der Leiterplatte hergestellt werden.

Nach diesem Verfahrensschritt wird ein Wärmeleitelement in den Durchbruch eingebracht. Das Wärmeleitelement wird im Durchbruch der Leiterplatte bevorzugt befestigt. Dies kann beispielsweise mittels Ankleben mit einem thermisch beständigen Klebstoff oder durch Anlöten des Wärmeleitelements geschehen. Beim Wärmeleitelement handelt es sich beispielsweise um ein Kupferplättchen oder eine Kupferniete. Bevorzugt ist das Kupferplättchen zumindest an seiner der Oberseite der Leiterplatte zugewandten Oberfläche mit einem thermisch leitenden und elektrisch isolierenden Material beschichtet. Besonders bevorzugt enthält diese Schicht diamantartigen Kohlenstoff.

In einem weiteren Verfahrensschritt kann die Unterseite der Leiterplatte mit diamantartigem Kohlenstoff beschichtet werden. Bevorzugt bedeckt diese Schicht sowohl das Wärmeleitelement als auch die restliche Oberfläche der Leiterplattenunterseite zumindest teilweise. Auf diese Weise kann das Wärmeleitelement besonders gut leitend an die restliche Unterseite der Leiterplatte gekoppelt werden.

Es wird ferner die Verwendung eines mit diamantartigem Kohlenstoff beschichteten Körpers zur Ableitung der Wärme von einem optoelektronischen Bauelement beschrieben. Bei dem Körper kann es sich beispielsweise um ein Wärmeleitelement handeln. Das Wärmeleitelement enthält bevorzugt ein thermisch gut leitendes Material und ist zumindest an einer seiner Oberflächen mit diamantartigem Kohlenstoff beschichtet. Der Körper kann aber auch das optoelektronische Bauelement sein, das stellenweise mit diamantartigem Kohlenstoff beschichtet ist. Bevorzugt ist das Bauteil dabei an Flächen des Bauteils beschichtet, über die besonders viel Wärme an die Umgebung abgegeben werden kann. So kann beispielsweise ein thermisches Anschlussteil des Bauteils mit diamantartigem Kohlenstoff beschichtet sein. Es ist aber auch möglich, dass Teile der Oberfläche des Halbleiterchips, des Chipträgers oder einer Kontaktmetallisierung des Chips mit diamantartigem Kohlenstoff beschichtet sind.

Im Folgenden wird die hier beschriebene Leiterplatte anhand von Ausführungsbeispielen und den dazugehörigen Figuren näher erläutert.

Figur 1 zeigt eine schematische Schnittdarstellung eines ersten Ausführungsbeispiels einer hier beschriebenen Leiterplatte.

Figur 2 zeigt eine schematische Schnittdarstellung eines zweiten Ausführungsbeispiels einer hier beschriebenen Leiterplatte.

Figur 3 zeigt ein Ausführungsbeispiel der hier beschriebenen optoelektronischen Anordnung.

Figur 4 zeigt eine perspektivische Schnittdarstellung eines Ausführungsbeispiels eines Gehäuses einer Leuchtdiode, wie sie in der optoelektronischen Anordnung Verwendung finden kann.

In den Ausführungsbeispielen und Figuren sind gleiche und gleich wirkende Bestandteile jeweils mit den gleichen Bezugszeichen versehen. Die dargestellten Bestandteile sowie die Größenverhältnisse der Bestandteile untereinander sind nicht als maßstabsgerecht anzusehen. Vielmehr sind einige Details der Figuren zum besseren Verständnis übertrieben groß dargestellt.

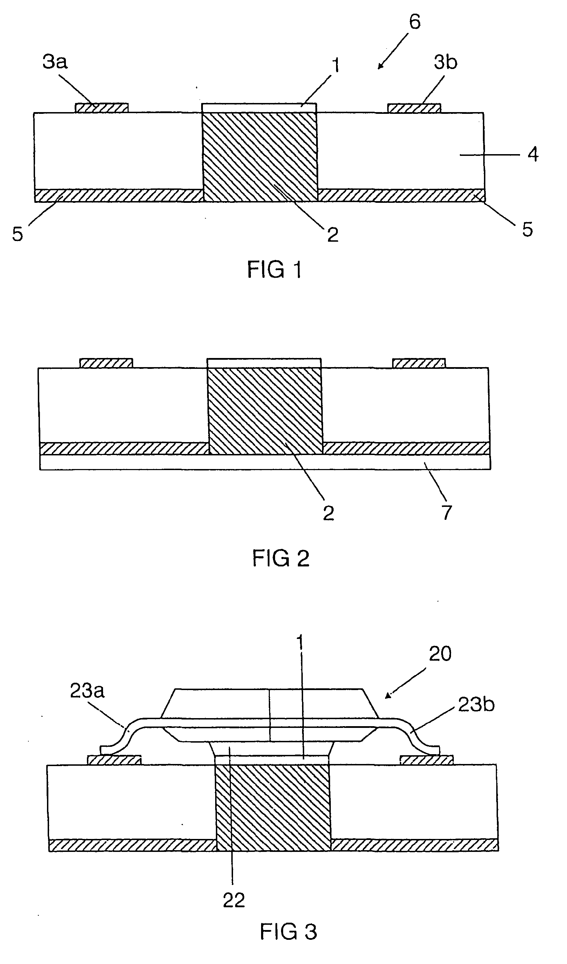

Figur 1 zeigt eine Schnittdarstellung eines ersten Ausführungsbeispiels einer hier beschriebenen Leiterplatte. Die Leiterplatte 6 weist einen Grundkörper 4 aus beispielsweise FR4 auf. Beispielsweise ist die Leiterplatte 6 durch eine doppelseitig mit Kupfer beschichtete FR4 Platine gegeben. Es sind jedoch auch andere Platinenmaterialen wie FR2, FR3, CEM1, CEM2, Teflon, Armaid oder andere Materialien als Grundkörper der Platine denkbar.

Der Grundkörper ist dabei bevorzugt zwischen 1,4 und 2,4 mm dick. Auf den Grundkörper 4 sind die elektrischen Anschlussstellen 3a, b aufgebracht, die zum Anschließen und elektrischen Kontaktieren eines Bauteils dienen. Bevorzugt enthalten die Anschlussstellen 3a, b Kupfer. Auf die Unterseite des Leiterplattengrundkörpers 4 kann eine Kupferschicht 5 aufgebracht sein.

Weiter weist die Leiterplatte 6 einen Durchbruch, zum Beispiel eine Bohrung, auf, in die ein Wärmeleitelement 2 eingesetzt ist. Zur mechanischen Befestigung an den Grundkörper 4 ist das Wärmeleitelement 2 beispielsweise thermisch beständig angeklebt oder angelötet. Der Durchmesser des Wärmeleitelements 2 entspricht dabei bevorzugt in etwa dem Durchmesser der Bohrung. Der Durchmesser kann bevorzugt der Fläche des thermischen Anschlussteils 22 eines auf die Leiterplatte 6 zu montierenden Bauteils 20 (siehe Figur 3) angepasst sein. Der Durchmesser des Wärmeleitelements 2 beträgt beispielsweise zwischen 3 und 5 mm.

Bevorzugt ist das Wärmeleitelement 2 durch ein Kupferplättchen gegeben. Das Wärmeleitelement 2 ist bevorzugt ein Vollkörper, der aus Kupfer besteht. Alternativ ist es aber auch möglich, dass das Wärmeleitelement aus einem anderen gut thermisch leitenden Material besteht.

Im vorliegenden Ausführungsbeispiel ist auf das Wärmeleitelement 2 eine thermisch leitende und elektrisch isolierende Schicht 1 aufgebracht. Die Schicht 1 besteht aus diamantartigem Kohlenstoff (DLC) und ist mittels eines Plasmabeschichtungsverfahrens aufgebracht. Die Dicke der Schicht 1 beträgt bevorzugt ca. 2 *µ*m. Sie weist einen spezifischen elektrischen Widerstand von ca. 10¹⁰ Ωm und eine Wärmeleitfähigkeit von 500 bis 700 W/mK auf. Die Schicht verbessert die thermische Kopplung eines mit der Schicht 1 verbundenen optoelektronischen Bauteils 20 und des Wärmeleitelements 2 erheblich. Es besteht eine feste mechanische Verbindung zwischen der Schicht 1 und dem Wärmeleitelement 2. Mit Hilfe der Schicht lässt sich der Wärmewiderstand für die Strecke vom thermischen Anschlussteil 22 des optoelektronischen Bauteils 20 zur Platinenunterseite bei Verwendung eines Wärmeleitelements aus Kupfer auf ca. 0,1 K/W reduzieren. Dies ist ca. 1/10 des Wärmewiderstands ohne eine thermisch leitende und elektrisch isolierende Schicht 1. Nur das Wärmeleitelement 2 trägt dann noch nennenswert zum thermischen Widerstand der Anordnung bei.

Figur 2 zeigt ein weiteres Ausführungsbeispiel der beschriebenen Leiterplatte. Hier ist auf der Unterseite der Leiterplatte 6 eine Unterseitenbeschichtung 7 aufgebracht. Die Unterseitenbeschichtung 7 besteht bevorzugt aus diamantartigem Kohlenstoff. Ihre Dicke beträgt bevorzugt zwischen 1 µm und 3 *µ*m. Vorteilhaft bedeckt die Unterseitenbeschichtung 7 die Unterseite der Leiterplatte 6 möglichst vollständig. Dadurch bedeckt die Unterseitenbeschichtung 7 auch die Unterseite des Wärmeleitelements 2 bevorzugt vollständig. Zum einen dient die Unterseitenbeschichtung 7 einem flächigen Verteilen der Wärme, die durch das Wärmeleitelement 2 tritt, auf der Unterseite der Leiterplatte 6. Zum anderen verbessert die Unterseitenbeschichtung 7 die thermische Kopplung zwischen Leiterplatte 6 und einem Kühlkörper, auf den die Leiterplatte 6 beispielsweise mit ihrer Unterseite aufgebracht sein kann. Die Unterseitenbeschichtung 7 bedeckt dabei wie in Figur 2 gezeigt auch die Kupferschicht 5 möglichst vollständig.

Es ist darüber hinaus auch möglich, dass nur das Wärmeleitelement 2 an seiner Unterseite eine Unterseitenbeschichtung 7 aufweist und die restliche Unterseite der Leiterplatte 6 unbeschichtet ist. Auf diese Weise kann Wärme vom Wärmeleitelement 2 direkt an einen Kühlkörper abgegeben werden, ohne dass die Wärme vorher flächig auf der Leiterplattenunterseite 7 verteilt wird.

Figur 3 zeigt ein Ausführungsbeispiel der beschriebenen optoelektronischen Anordnung. Es ist hier beispielhaft eine optoelektronische Anordnung mit einer Leuchtdiode 20 gezeigt. Die elektrischen Anschlussteile 23a, b der Leuchtdiode sind auf die Anschlussstellen 3a, b der Leiterplatte 6 beispielsweise aufgelötet. Das thermische Anschlussteil 22 der Leuchtdiode ist auf die thermisch leitende und elektrisch isolierende Schicht 1 aufgelötet oder thermisch beständig aufgeklebt. Alternativ ist die Schicht 1 durch eine Beschichtung des thermischen Anschlussteils 22 der Leuchtdiode gebildet. Die Schicht 1 ist dann auf das Wärmeleitelement 2 beispielsweise aufgeklebt oder aufgelötet. Zudem können sowohl die Leuchtdiode 20 an ihrem thermischen Anschlussteil 22, als auch das Wärmleitelement 2 eine thermisch leitende und elektrisch isolierende Schicht 1 aufweisen.

Bevorzugt handelt es sich bei der Leuchtdiode 20 um eine Hochleistungs-Leuchtdiode mit wenigstens 1 W Leistungsaufnahme. Die Leuchtdiode 20 kann dabei beispielsweise zur Emission von weißem Licht geeignet sein.

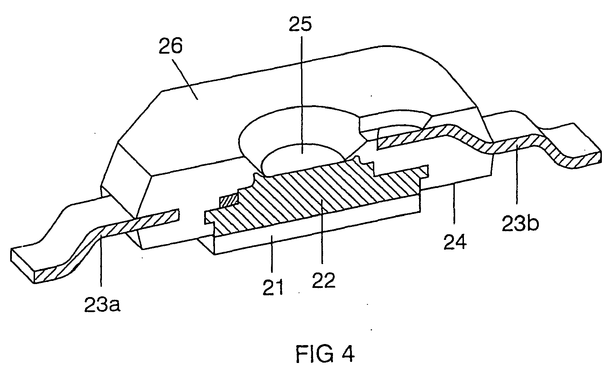

Figur 4 zeigt eine perspektivische Schnittdarstellung eines Gehäuses einer hier beschriebenen Leuchtdiode 20. Das Gehäuse weist beispielsweise einen Grundkörper 26 auf, der aus einer Kunststoffformmasse bestehen kann und beispielsweise mittels eines Spritzguss- oder Spritzpressverfahrens hergestellt sein kann. Die Formmasse enthält beispielsweise ein Kunststoffmaterial auf der Basis eines Epoxidharzes oder eines Acrylharzes. In den Grundkörper 26 sind das thermische Anschlussteil sowie die elektrischen Anschlussteile 23a, b eingebettet. Auf dem thermischen Anschlussteil 22 befindet sich der Chipmontagebereich 25, auf dem ein Leuchtdiodenchip montiert werden kann.

Bei dem Leuchtdiodenchip kann es sich beispielsweise um einen Leuchtdiodenchip in Dünnfilmbauweise handeln, bei dem das Wachstumssubstrat entfernt ist, und über einen thermisch besonders gut leitenden Träger die beim Betrieb des Chips erzeugte Wärme an das thermische Anschlussteil 22 abgegeben wird. Ein Dünnfilm-Leuchtdioden-Chip kann sich insbesondere durch folgende charakteristische Merkmale auszeichnen:
- an einer zu einem Trägerelement hin gewandten ersten Hauptfläche einer strahlungserzeugenden Epitaxieschichtenfolge ist eine reflektierende Schicht aufgebracht oder ausgebildet, die zumindest einen Teil der in der Epitaxieschichtenfolge erzeugten elektromagnetischen Strahlung in diese zurückreflektiert;
- die Epitaxieschichtenfolge weist eine Dicke im Bereich von 20*µ*m oder weniger, insbesondere im Bereich von 10 µm auf; und
- die Epitaxieschichtenfolge enthält mindestens eine Halbleiterschicht mit zumindest einer Fläche, die eine Durchmischungsstruktur aufweist, die im Idealfall zu einer annähernd ergodischen Verteilung des Lichtes in der epitaktischen Epitaxieschichtenfolge führt, d.h. sie weist ein möglichst ergodisch stochastisches Streuverhalten auf.

Ein Grundprinzip eines Dünnschicht-Leuchtdiodenchips ist beispielsweise in I. Schnitzer et al., Appl. Phys. Lett. 63 (16), 18. Oktober 1993, 2174 - 2176 beschrieben, deren Offenbarungsgehalt insofern hiermit durch Rückbezug aufgenommen wird.

Ein Dünnfilm-Leuchtdioden-Chip ist in guter Näherung ein Lambert'scher Oberflächenstrahler und eignet sich von daher besonders gut für die Anwendung in einem Scheinwerfer.

Das thermische Anschlussteil 22 ist beispielsweise mit dem elektrischen Anschlussteil 23b elektrisch kontaktiert. Bevorzugt enthält das thermische Anschlussteil 22 ein gut elektrisch und thermisch leitendes Material, wie beispielsweise Kupfer. Bevorzugt besteht das Anschlussteil 22 aus Kupfer.

Die Unterseite der thermischen Anschlussstelle 22 kann mit einer Schicht 21 aus diamantartigem Kohlenstoff beschichtet sein. Dazu steht die Unterseite des thermischen Anschlussteils 22 bevorzugt leicht über die Unterseite 24 des Grundkörpers 26 hervor. Bei der Schicht 21 kann es sich sowohl um eine zusätzliche Beschichtung mit diamantartigem Kohlenstoff als auch um die Schicht 1 handeln. Wegen ihres hohen elektrischen Widerstands trägt die Schicht 21 neben ihrer sehr guten Wärmeleiteigenschaft auch zur elektrischen Entkopplung der Leuchtdiode bei.

Diese Patentanmeldung beansprucht die Priorität der deutschen Patentanmeldung 102004036960.7-34, deren Offenbarungsgehalt hiermit durch Rückbezug aufgenommen wird.

Die Erfindung ist nicht durch die Beschreibung anhand der Ausführungsbeispiele beschränkt. Vielmehr umfasst die Erfindung jedes neue Merkmal sowie jede Kombination von Merkmalen, insbesondere jede Kombination von Merkmalen in den Patentansprüchen, auch wenn dieses Merkmal oder diese Kombination selbst nicht explizit in den Patentansprüchen oder Ausführungsbeispielen angegeben ist.

## Patentansprüche

1. Leiterplatte, aufweisend
eine thermisch leitende und elektrisch isolierende Schicht (1) an der Oberseite der Leiterplatte (6) und ein Wärmeleitelement (2), das die Schicht (1) thermisch mit der Unterseite der Leiterplatte (6) verbindet.

2. Leiterplatte nach Anspruch 1,
bei der die Schicht (1) wenigstens ein Material enthält, das einen spezifischen elektrischen Widerstand von wenigstens 10² Ωm und eine thermische Leitfähigkeit von wenigstens 10² W/mK aufweist.

3. Leiterplatte nach einem der Ansprüche 1 oder 2,
bei der die Schicht (1) diamantartigen Kohlenstoff enthält.

4. Leiterplatte nach einem der Ansprüche 1 bis 3,
bei der die Schicht (1) eine Dicke zwischen 1 µm und 3*µ*m aufweist.

5. Leiterplatte nach einem der Ansprüche 1 bis 4,
bei der das Wärmeleitelement (2) die Schicht (1) auf direktem Weg mit der Unterseite der Leiterplatte (6) verbindet.

6. Leiterplatte nach einem der Ansprüche 1 bis 5,
bei der die Schicht (1) durch eine Beschichtung zumindest eines Teils der Oberfläche des Wärmeleitelements (2) gegeben ist.

7. Leiterplatte nach einem der Ansprüche 1 bis 6,
bei der das Wärmeleitelement (2) ein Metall enthält.

8. Leiterplatte nach einem der Ansprüche 1 bis 7,
bei der die Leiterplatte (6) einen Durchbruch aufweist, in dem das Wärmeleitelement (2) angeordnet ist.

9. Leiterplatte nach einem der Ansprüche 1 bis 8,
bei der die Leiterplatte (6) wenigstens eines der folgenden Materialien enthält: Kupfer, FR4.

10. Leiterplatte nach einem der Ansprüche 1 bis 9,
bei der die Unterseite der Leiterplatte (6) zumindest teilweise mit einem thermisch leitenden und elektrisch isolierenden Material (7) beschichtet ist.

11. Leiterplatte nach Anspruch 10,
bei der die Unterseitenbeschichtung (7) der Leiterplatte (6) diamantartigen Kohlenstoff enthält.

12. Leiterplatte nach einem der Ansprüche 10 oder 11,
bei der die Unterseitenbeschichtung (7) der Leiterplatte (6) eine Dicke zwischen 1 µm und 3 µm aufweist.

13. Optoelektronische Anordnung, aufweisend
eine Leiterplatte (6) nach einem der oben genannten Ansprüche und ein optoelektronisches Bauteil (20), das sich zumindest stellenweise mit der Schicht in Kontakt befindet.

14. Anordnung nach Anspruch 13,
bei der die Schicht (1) durch eine zumindest teilweise Beschichtung (21) des Teils des optoelektronischen Bauteils (20) gegeben ist, der sich in Kontakt mit dem Wärmeleitelement (2) befindet.

15. Anordnung nach Anspruch 13,
bei der zumindest der Teil des optoelektronischen Bauteils (20), der sich in Kontakt mit der Schicht (1) befindet, mit einem thermisch leitenden und elektrisch isolierenden Material (21) beschichtet ist.

16. Anordnung nach Anspruch 15,
bei der die Beschichtung (21) des optoelektronischen Bauteils (20) diamantartigen Kohlenstoff enthält.

17. Anordnung nach einem der Ansprüche 13 bis 16,
bei der das optoelektronische Bauteil (20) eine elektrische Leistungsaufnahme von wenigstens einem Watt aufweist.

18. Anordnung nach einem der Ansprüche 13 bis 17,
bei der das optoelektronische Bauteil (20) eines der folgenden Bauteile ist: Leuchtdiode, Laserdiode.

19. Verfahren zur Herstellung einer Leiterplatte, aufweisend die folgenden Schritte:
a) Bereitstellen einer Leiterplatte (6);
b) Herstellen eines Durchbruchs in der Leiterplatte (6);
c) Einbringen eines Wärmeleitelements (2) in den Durchbruch der Leiterplatte (6);
d) Beschichtung (7) von zumindest Teilen der Unterseite der Leiterplatte (6) mit diamantartigem Kohlenstoff.

20. Verwendung eines mit diamantartigem Kohlenstoff beschichteten Körpers (2,22) zur Ableitung der Wärme von einem optoelektronischen Bauelement.

21. Verwendung nach Anspruch 20,
wobei der Körper (2,22) aus Kupfer besteht.
